# EUROPEAN PATENT SPECIFICATION

(11) **EP 0 564 280 B1**
(45) Date of publication and mention of the grant of the patent: **16.09.1998**
(21) Application number: 93302561.1
(22) Date of filing: 31.03.1993
(51) Int. Cl.: G11C 5/14

(54) **Circuit for generating an internal source voltage**
Schaltung zur Erzeugung einer Innenquellenspannung
Circuit pour produire une tension de source interne

(30) Priority: 31.03.1992 KR 535092
(43) Date of publication of application: 06.10.1993
(73) Proprietor: SAMSUNG ELECTRONICS CO., LTD., Suwon-city, Kyungki-do 441-373 (KR)
(72) Inventor: Suh, Young-Ho, Suwon, Kyungki-do (KR); Kim, Suk-Bin, Seoul (KR)
(74) Representative: Stanley, David William

(56) References cited:
- EP-A- 0 345 065
- DE-A- 4 115 082
- FR-A- 2 680 585
- IEEE JOURNAL OF SOLID-STATE CIRCUITS. vol. 25, no. 5 , October 1990 , NEW YORK US pages 1082 - 1091 OOTANI ET AL 'A 4-Mb CMOS SRAM with a PMOS thin-film-transistor load cell'

## Description

The present invention relates to circuits for generating an internal source voltage - especially for semiconductor memory devices.

As semiconductor memory devices have become highly integrated, the memory elements installed in a memory device have been gradually miniaturized. Hence, if an external voltage supplied to the memory device is not properly adjusted, a strong electric field may be formed to cause a stress applied to the memory device, thereby damaging the memory elements. A semiconductor memory device of 16 Mega bits or above should employ a circuit for generating an internal voltage to drop the level of the external voltage to the level of the operating voltage of the memory device. For example, a semiconductor memory device of 16 Mega bits or above should use the internal voltage of 4V which is usually obtained by dropping the external voltage of 5V.

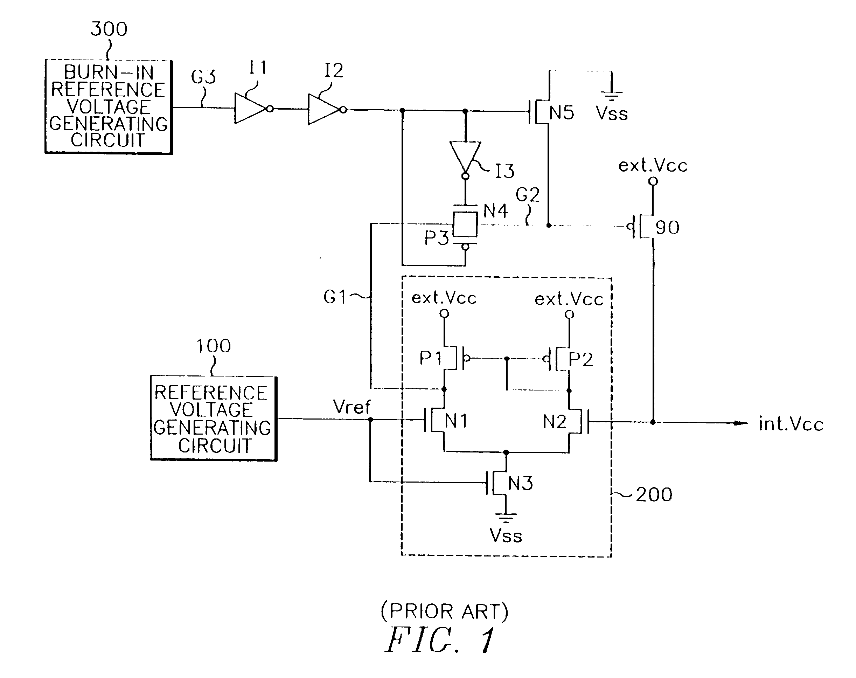

Figure 1 of the accompanying diagrammatic drawings shows a circuit for generating an internal source voltage according to the prior art, and includes a reference voltage generating circuit 100 for generating a reference voltage Vref, a comparator 200 for comparing an internal source voltage int.Vcc with the reference voltage Vref, a driver 90 for driving an external voltage ext.Vcc to the internal source voltage int.Vcc under the control of the comparator 200, and a burn-in reference voltage generating circuit 300. The comparator 200 comprises NMOS transistors N1, N2, N3 and PMOS transistors P1, P2, connected between the external voltage ext.Vcc and ground voltage Vss. The internal source voltage int.Vcc is applied to the memory elements of the memory device as well as an NMOS transistor N2 of the comparator 200. If the internal source voltage int.Vcc drops below the reference voltage Vref due to power consumption of the memory elements, the level of an output signal G1 of the comparator 200 is lowered so as to fully turn on the driver 90 to compensate for the dropping of the internal source voltage int.Vcc. Alternatively, if the internal source voltage int.Vcc increases above the reference voltage Vref, the output signal G1 of the comparator 200 is increased so as to turn off the driver 90 to drop the internal source voltage int. Vcc to the reference voltage Vref.

In order to perform a burn-in operation, if the voltage level of the external source voltage ext.Vcc is higher than the voltage level of the burn-in reference voltage, the burn-in reference voltage generating circuit 300 generates an output signal G3 of a logic "high" state so as to turn off transmission gates N4, P3 through inverters I1, I2 and I3, and turn on a pull down transistor N5, so that the external source voltage ext.Vcc is applied to the memory device through the driver 90. In this case, since the transmission gate N4, P3 is turned off, the output signal G1 of the comparator 200 does not affect a signal G2 which is applied to a gate of the driver 90.

In such a conventional circuit for generating the internal source voltage, if the voltage level of the external source voltage ext.Vcc is lower than the voltage level of the reference voltage Vref, the transmission gate N4, P3 is turned on so as to cause the output signal G1 of the comparator to affect the driver 90. Consequently, when the internal source voltage int.Vcc is changed by a peak current generated in the memory device, the voltage G2 is changed so as to instantly drop the internal source voltage int.Vcc below the external source voltage, so that the operating speed of the memory elements is slowed down to cause an erroneous function.

IEEE Journal of Solid State Circuits, Vol. 25, No. 5 describes a circuit for generating an internal source voltage (int.VCC) from a given external source voltage (Ext.VCC). The internal VCC is for application to the memory elements of a semiconductor device (4-Mb CMOS SRAM). A voltage generating means (Vref Generator) is described for generating a reference voltage (Vref), a comparing means (Diff. Amp. for 5-V Standby) for comparing int.VCC with Vref and a driving means consisting of the PMOS transistor that has its gate connected to the output of the Diff. Amp. and a PMOS transistor for Battery Back Up. The first of these PMOS transistors drives the external source voltage into the internal source voltage under the control of the comparing means. A control means (Ext.VCC Level Sensor) generates a control signal (*phi*VEXT1) which disables the comparing means by switching off of the Diff. Amp and fully turns on the second PMOS transistor of the driving means when Ext.VCC is lower than Vref.

Preferred embodiments of the present invention aim to provide a circuit for generating an internal source voltage for supplying an external source voltage directly to the memory elements of a semiconductor memory device when the voltage level of the external source voltage is lower than the voltage level of a reference voltage.

It is another aim to provide a circuit for generating an internal source voltage for preventing the operating speed of the memory elements from being slowed down due to instant dropping of the internal source voltage.

According to the invention, there is provided a circuit for generating upon receipt of a given external source voltage an internal source voltage to be applied to memory elements of a semiconductor device, said circuit comprising:
a first reference voltage generating means (100) for generating a reference voltage (Vref);
comparing means (200) for comparing said internal source voltage (int.Vcc) with said reference voltage (Vref);
means (90) for driving the external source voltage (ext.Vcc) into said internal source voltage (int.Vcc) under control of said comparing means (200); and
a control means (500) for generating a control signal (G4) to fully turn on said driving means (90), when the level of said external source voltage (ext.Vcc) falls below the level of said reference voltage (Vref), so as to apply said external source voltage (ext.Vcc) to said memory elements;
**characterized in that**:
   said driving means is a driving transistor (90); and
   said control signal (G4) prevents said driving transistor (90) from receiving the output signal (G1) of said comparing means (200).

Preferably, the state of said control signal of said control means is changed according to the voltage level of said external source voltage.

Preferably, said control means includes a signal generating means (400) for generating an output signal (Vout) by comparing the external source voltage (ext.Vcc) with said reference voltage (Vref').

Preferably, said signal generating means comprises at least a voltage comparator and a voltage divider.

A circuit as above may further comprise means for generating a burn-in voltage for preventing said driving means from receiving the output of said comparing means and for fully turning on said driving means for a burn-in operation.

The invention extends to a semiconductor device provided with a circuit according to the invention.

For a better understanding of the invention, and to show how the same may be carried into effect, reference will now be made, by way of example, to the accompanying diagrammatic drawings, in which:
Figure 2 is a schematic diagram illustrating one example of a circuit for generating an internal source voltage according to one embodiment of the present invention; and
Figure 3 is a schematic diagram illustrating a low reference voltage generating circuit of Figure 2.

In the figures, like reference numerals denote like or corresponding parts.

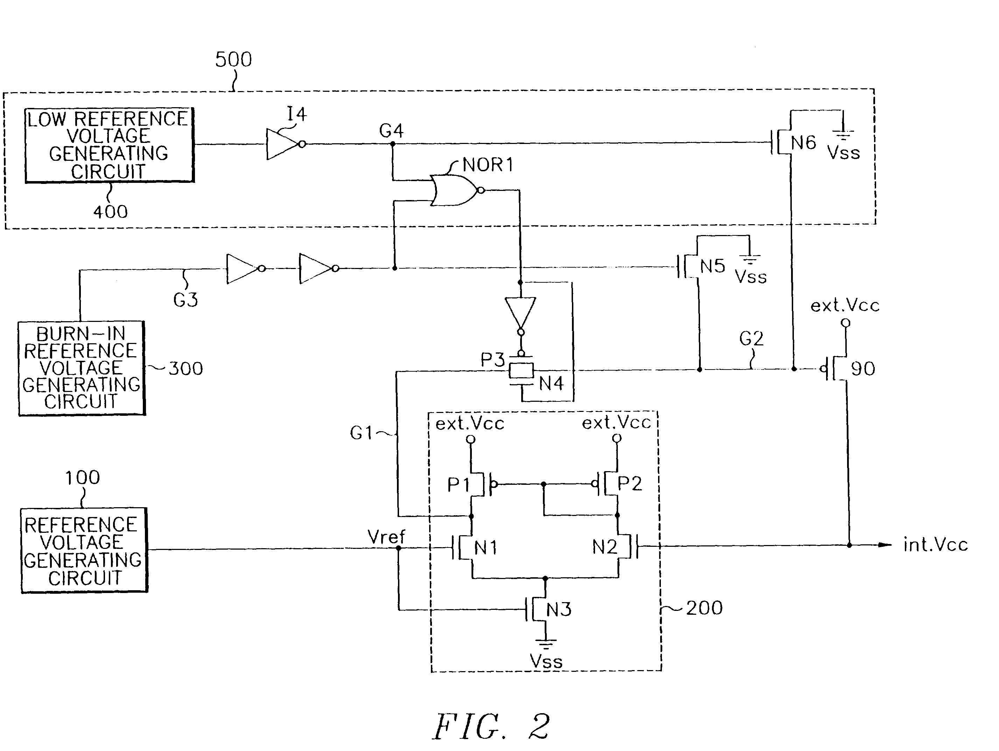

Referring to Figure 2, a reference voltage generating circuit 100 generates a reference voltage Vref. A comparator 200 compares an internal source voltage int.Vcc with the reference voltage Vref. A driver 90 drives an external source voltage ext.Vcc into the internal source voltage int.Vcc under the control of the comparator 200. A burn-in reference voltage generating circuit 300 generates an output signal G3 to prevent the driver 90 from receiving an output signal G1 of the comparator and to fully turn on the driver 90. The signal G3 passes through a pair of inverters, and then through a further inverter to a transmission gate N4, P3. Thus far, the circuit is similar to that of Figure 1.

In Figure 2, however, an additional circuit portion 500 includes a low reference voltage generating circuit 400 is to generate a control signal to prevent the driver 90 from receiving the output signal G1 from the comparator and to fully turn on the driver 90 when the voltage level of the external source voltage ext. Vcc is lower than the voltage level of the reference voltage Vref.

The burn-in reference voltage generating circuit 300 generates the output signal G3 at a logic "high" state to turn off transmission gate N4, P3, and to turn on a pull-down transistor N5, so that a signal G2 of a logic "low" state is applied to a gate of the driver 90. Consequently the driver 90 is turned on, so that the external source voltage ext.Vcc is directly applied to the memory elements.

If the voltage level of the external source voltage ext.Vcc is lower than the voltage level of the reference voltage Vref, the low reference voltage generating circuit 400 generates an output signal of a logic "low" state. The output signal of the low reference voltage generator 400 becomes a signal G4 of a logic "high" state by an inverter I4. Hence, an output signal of a NOR-gate NOR1 has a logic " low " state, thus turning off the transmission gates N4, P3. In addition, the signal G4 of a logic "high" state turns on a pull-down transistor N6. Accordingly, the voltage level of G2 becomes a ground voltage level Vss, so that the driver 90 is fully turned on so as to apply the external source voltage ext.Vcc to the memory elements of the memory device. Meanwhile, the transmission gates N4, P3 are turned off to prevent the driver 90 from receiving the output G1 of the comparator 200. This causes the external source voltage ext.Vcc to be stably applied to the memory elements even if the voltage level of the internal source voltage int.Vcc is lower than the voltage level of the reference voltage Vref. Hence the operating speed of the memory device is properly maintained.

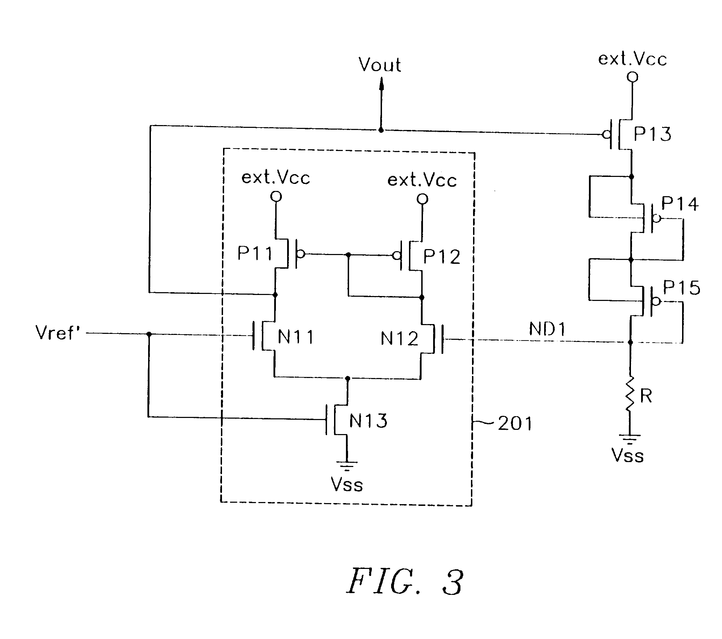

The low reference voltage generating circuit 400 in the circuit for generating the internal source voltage is shown in Figure 3. If a voltage Vref' is constant, the sizes of PMOS transistors P14 and P15 with diode characteristics and the value of a resistor R may be adjusted so as to establish a desired voltage level of a node ND1 by a voltage division. Comparator 201, comprising NMOS transistor N11, N12, N13 and PMOS transistors P11, P12, compares the voltage level of node ND1 with the voltage Vref', and outputs a corresponding output signal Vout, which controls a PMOS transistor P13 in series with transistors P14, P15.

When the external source voltage ext.Vcc is applied, the voltage level of the node ND1 becomes lower than the voltage level of the voltage Vref' after the voltage level of the node ND1 becomes equal to the voltage level of the voltage Vref'. Hence, an output signal Vout of a logic "low" state becomes the output signal G4 at a logic "high" state through the inverter I4 at Figure 2.

Thus, if the voltage level of the external source voltage is higher than the voltage level of the reference voltage, the internal source voltage of a predetermined voltage level is applied to the memory elements by the illustrated inventive circuit. Alternatively, if the voltage level of the external source voltage is lower than the voltage level of the reference voltage, the external source voltage is directly applied to the memory elements, thus improving the operating speed.

The term "ground potential" (or like terms such as "ground voltage" or "earth" potential or voltage) is used conveniently in this specification to denote a reference potential. As will be understood by those skilled in the art, although such reference potential may typically be zero potential, it is not essential that it is so, and may be a reference potential other than zero.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination. of the features disclosed in this specification (including any accompanying claims. abstract and drawings), or to any novel one, or any novel combination, of the steps of any method or process so disclosed.

## Claims

1. A circuit for generating upon receipt of a given external source voltage (ext.Vcc) an internal source voltage (int.Vcc) to be applied to memory elements of a semiconductor device, said circuit comprising:
a first reference voltage generating means (100) for generating a reference voltage (Vref);
comparing means (200) for comparing said internal source voltage (int.Vcc) with said reference voltage (Vref);
means (90) for driving the external source voltage (ext.Vcc) into said internal source voltage (int.Vcc) under control of said comparing means (200); and
a control means (500) for generating a control signal (G4) to fully turn on said driving means (90), when the level of said external source voltage (ext.Vcc) falls below the level of said reference voltage (Vref), so as to apply said external source voltage (ext.Vcc) to said memory elements;
**characterized in that**:
said driving means is a driving transistor (90); and
said control signal (G4) prevents said driving transistor (90) from receiving the output signal (G1) of said comparing means (200).

2. A circuit as defined in Claim 1, wherein the state of said control signal (G4) of said control means (500) is changed according to the voltage level of said external source voltage (ext.Vcc).

3. A circuit as defined in claim 1 or 2, wherein said control means (500) includes a signal generating means (400) for generating an output signal (Vout) by comparing the external source voltage (ext.Vcc) with said reference voltage (Vref').

4. A circuit as defined in Claim 3, wherein said signal generating means (400) comprises at least a voltage comparator (201) and a voltage divider (P14, P15, R).

5. A circuit as defined in any of the preceding claims, further comprising means (300) for generating a burn-in voltage for preventing said driving means (90) from receiving the output of said comparing means (200) and for fully turning on said driving means (90) for a burn-in operation.

6. A semiconductor device provided with a circuit according to any of the preceding claims.

## Patentansprüche

1. Schaltung zum Erzeugen bei Empfang einer gegebenen externen Quellenspannung (ext. Vcc) einer an Speicherelemente einer Halbleitervorrichtung anzulegenden internen Quellenspannung (int.Vcc), mit folgenden:
einem ersten Bezugsspannungserzeugungsmittel (100) zum Erzeugen einer Bezugsspannung (Vref) ;
einem Vergleichungsmittel (200) zum Vergleichen der besagten internen Quellenspannung (int.Vcc) mit der besagten Bezugsspannung (Vref) ;
einem Mittel (90) zum Treiben der externen Quellenspannung (ext.Vcc) in die besagte interne Quellenspannung (int.Vcc) unter Steuerung des besagten Vergleichungsmittels (200); und
einem Steuermittel (500) zum Erzeugen eines Steuersignals (G4) zum vollen Einschalten des besagten Treibermittels (90), wenn der Pegel der besagten externen Quellenspannung (ext.Vcc) den Pegel der besagten Bezugsspannung (Vref) unterschreitet, um die besagte externe Quellenspannung (ext.Vcc) an die besagten Speicherelemente anzulegen;
dadurch gekennzeichnet, daß
das besagte Treibermittel ein Treibertransistor (90) ist; und
das besagte Steuersignal (G4) den besagten Treibertransistor (90) daran hindert, das Ausgangssignal (G1) des besagten Vergleichungsmittels (200) zu empfangen.

2. Schaltung nach Anspruch 1, wobei der Zustand des besagten Steuersignals (G4) des besagten Steuermittels (500) entsprechend dem Spannungspegel der besagten externen Quellenspannung (ext.Vcc) verändert wird.

3. Schaltung nach Anspruch 1 oder 2, wobei das besagte Steuermittel (500) ein Signalerzeugungsmittel (400) zum Erzeugen eines Ausgangssignals (Vout) durch Vergleichen der externen Quellenspannung (ext.Vcc) mit der besagten Bezugsspannung (Vref) enthält.

4. Schaltung nach Anspruch 3, wobei das besagte Signalerzeugungsmittel (400) mindestens einen Spannungsvergleicher (201) und einen Spannungsteiler (P14, P15, R) umfaßt.

5. Schaltung nach einem der vorhergehenden Ansprüche, weiterhin mit einem Mittel (300) zum Erzeugen einer Einbrennspannung zum Verhindern, daß das besagte Treibermittel (90) die Ausgabe des besagten Vergleichungsmittels (200) empfängt und zum vollen Einschalten des besagten Treibermittels (90) für eine Einbrennoperation.

6. Mit einer Schaltung nach einem der vorhergehenden Ansprüche versehene Halbleitervorrichtung.

## Revendications

1. Circuit de génération sur réception d'une tension de source externe donnée (Vcc ext.) d'une tension de source interne (Vcc int.) à appliquer aux éléments de mémoire d'un dispositif semi-conducteur, ledit circuit comprenant :
un premier moyen de génération de tension de référence (100) pour générer une tension de référence (Vréf.) ;
un moyen de comparaison (200) pour comparer ladite tension de source interne (Vcc int.) à ladite tension de référence (Vréf.) ;
un moyen (90) pour entraîner la tension de source externe (Vcc ext.) dans ladite tension de source interne (Vcc int.) sous la commande dudit moyen de comparaison (200) ; et
un moyen de commande (500) pour générer un signal de commande (G4) en vue de débloquer totalement ledit moyen d'entraînement (90), quand le niveau de ladite tension de source externe (Vcc ext.) chute en-dessous du niveau de ladite tension de référence (Vréf.), de manière à appliquer ladite tension de source externe (Vcc ext.) auxdits éléments de mémoire ;
caractérisé en ce que :
ledit moyen d'entraînement est un transistor d'attaque (90) ; et
ledit signal de commande (G4) empêche ledit transistor d'attaque (90) de recevoir le signal de sortie (G1) dudit moyen de comparaison (200).

2. Circuit selon la revendication 1, dans lequel l'état dudit signal de commande (G4) dudit moyen de commande (500) est changé conformément au niveau de tension de ladite tension de source externe (Vcc ext.).

3. Circuit selon la revendication 1 ou 2, dans lequel ledit moyen de commande (500) comporte un moyen de génération de signaux (400) pour générer un signal de sortie (Vsortie) en comparant la tension de source externe (Vcc ext.) à ladite tension de référence (Vréf.).

4. Circuit selon la revendication 3, dans lequel ledit moyen de génération de signaux (400) comprend au moins un comparateur de tension (201) et un diviseur de tension (P14, P15, R).

5. Circuit selon l'une quelconque des revendications précédentes, comprenant en outre un moyen (300) pour générer une tension de rodage afin d'empêcher ledit moyen d'entraînement (90) de recevoir la sortie dudit moyen de comparaison (200) et pour débloquer totalement ledit moyen d'entraînement (90) pour une opération de rodage.

6. Dispositif semi-conducteur muni d'un circuit selon l'une quelconque des revendications précédentes.
